Europäisches Patentamt

European Patent Office

Office européen des brevets

(11) Publication number: **0 148 448**
A2

## EUROPEAN PATENT APPLICATION

(21) Application number: 84115348.9

(22) Date of filing: 13.12.84

(51) Int. Cl.⁴: **H 01 L 21/306**

(30) Priority: 16.12.83 JP 236167/83

(43) Date of publication of application: 17.07.85
Bulletin 85/29

(84) Designated Contracting States: DE FR GB NL

(71) Applicant: HITACHI, LTD., 6, Kanda Surugadai 4-chome
Chiyoda-ku, Tokyo 100 (JP)

(72) Inventor: Sunami, Hideo, 2196-241, Hirai Hinode-machi,
Nishitama-gun Tokyo (JP)
Inventor: Tamura, Massao, 5-17-6, Nakaarai,
Tokorozawa-shi Saitama-ken (JP)

(74) Representative: Patentanwälte Beetz sen. - Beetz jun.
Timpe - Siegfried - Schmitt-Fumian,
Steinsdorfstrasse 10, D-8000 München 22 (DE)

(54) Etching method.

(57) Focused ion beams (4) are implanted in the substrate (2),
and a treatment method in which the etching rate varies with
the ion concentration is subsequently applied thereto,
whereby it is made possible to produce etching holes (5) hav-
ing various sectional patterns or even a tunnel-shaped etching
(51) in the substrate. It is also possible to produce patterns
projected on the substrate. The present method is arranged so
that the doping and the etching are self-aligned with each
other, and therefore it is fit for precision work and is very useful
for highly integrating a semiconductor device.

TITLE OF THE INVENTION

ETCHING METHOD

BACKGROUND OF THE INVENTION

i)    Field of the Invention

This invention, in the field of its application, relates to a micro-fabrication method, and more particularly to an etching method with less damage caused by ion bombardment.

ii)    Brief Description of the Prior Art

The prior etching method for the micro-fabrication of LSI, etc. using a Si substrate has heretofore comprised processing a photoresist and conducting a highly anisotropic dry etching on the substrate masked with said photoresist.  In general, the higher the anisotropicity, the higher the ion energy required, so that the prior art has been defective in that the Si substrate and adjoining materials are damaged by the intensified energy.

The conventional art has also been defective in that in some cases the photoresist itself is not fit for micro-fabrication because of its insufficient resistance to dry etching.

SUMMARY OF THE INVENTION

An object of this invention is to provide an etching method for forming a precision pattern, with little damage inflicted on the substrate, by employing an isotropic etching method wherein the material to be processed is irradiated with focused ion beams (hereinafter referred to as $\mu$ ion beams) so that the etching rate is varied with the varied irradiation dose, and little damage is caused thereby.

This invention provides an art represented by using an etching solution comprising a liquid mixture of HF and $HNO_3$ which has a property of providing, for example, $SiO_2$ with an etching rate widely varying with the concentration of phosphorus contained in the $SiO_2$ and thereby etching off selectively the precise spots of the $SiO_2$ part in which phosphorus has previously been implanted by means of $\mu$ ion beams, so that very finely etched holes can be formed even by the use of a solution.

BRIEF DESCRIPTION OF THE DRAWINGS

Fig. 1 is a sectional view of an embodiment of the method described in Example 1 of this invention.

Fig. 2 is a diagram showing the etching characteristics.

Fig. 3 is a diagram showing a sectional view of an etching hole formed by the method of Example 1.

Fig. 4 is a diagram showing a sectional view of an etching hole formed by the conventional method.

Fig. 5 is a diagram showing the method of Example 2.

Fig. 6 is a sectional view of an etching hole formed by the method of Example 2.

Fig. 7 is a sectional view of another etching hole formed by the method of Example 2.

Figs. 8 and 9 are diagrams showing the method of Example 3.

Figs. 10 and 11 are diagrams showing the method of Example 4.

Fig. 12 is a diagram showing the method of Example 5.

Fig. 13 is a sectional view of a projected pattern obtained by the method of Example 5.

Fig. 14 is a sectional view of an embodiment of the method of Example 6.

DETAILED DESCRIPTION OF THE PRESENTLY PREFERRED EMBODIMENTS

Example 1:

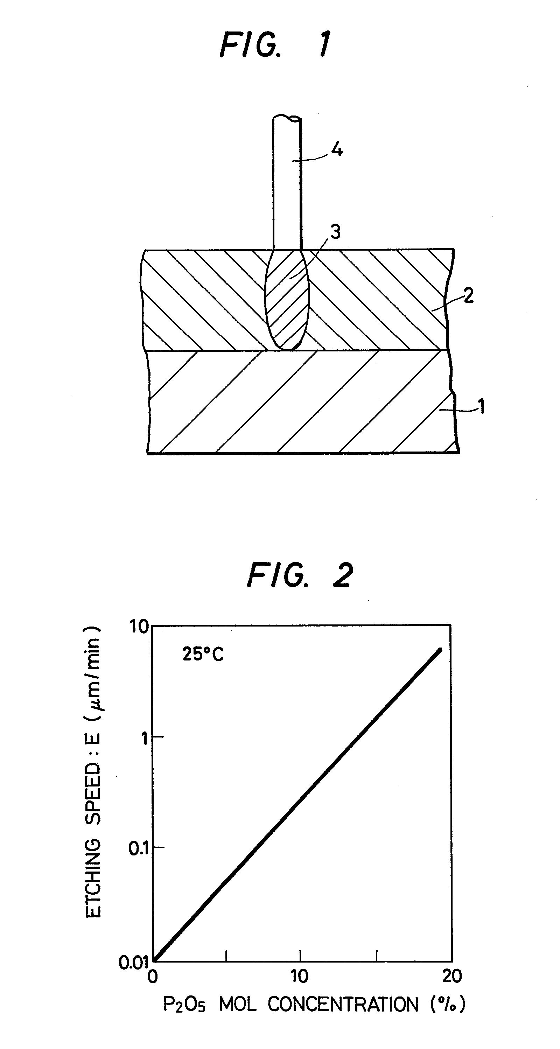

An embodiment of this invention will now be described in reference to Figs. 1 to 3. As shown in Fig. 1, a 0.2 $\mu$m-thick $SiO_2$ layer 2, for instance, is produced on a Si substrate by the conventional thermal oxidation method which is usually employed. Subsequently, a specified part is irradiated with a $\mu$ ion beam, 0.1 $\mu$mø, of elementary phosphorus 4 under energy of 200 keV to form a highly-doped $\mu$-ion layer 2, at a depth of about 0.2 $\mu$m from the surface, where the phosphorus concentration is at its peak depending on the intensity of energy applied.

The depth for the peak concentration is normally described as $R_p$, wherein the standard deviation $\sigma$ due to the distribution of concentration is 0.06 $\mu$m. Accordingly, the pipe-shaped part 3 shown in Fig. 1 can form a continuous implanted part which reaches the surface even when phosphorus is implanted with energy of lower than 200 keV.

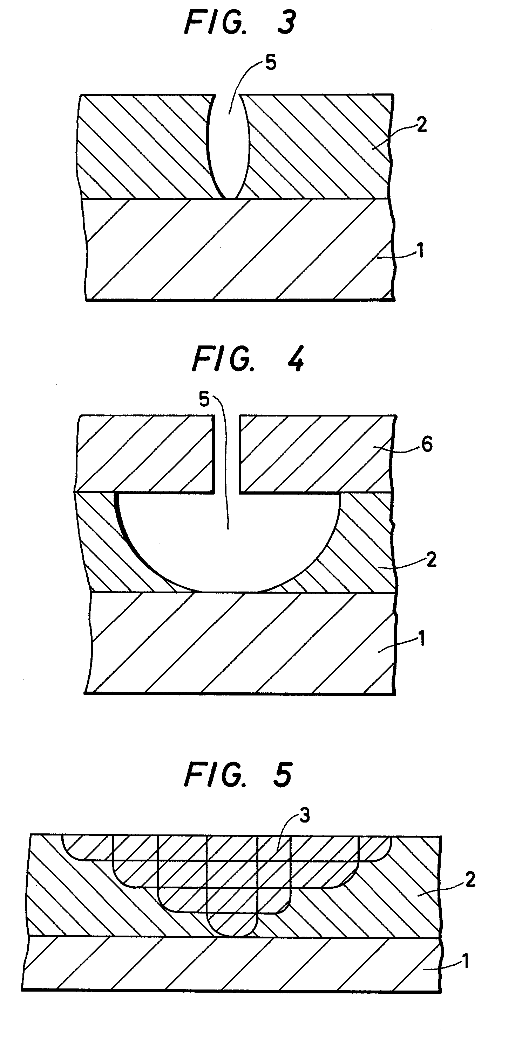

Subsequently, the entire surface is etched with the so-called P-etching solution (HF : 3, $HNO_3$ : 2 and $H_2O$ : 60). The etching rate by this solution varies widely with the concentration of phosphorus in $SiO_2$. As shown by the etching characteristics in Fig. 2, the etching rate for $SiO_2$ in which no phosphorus has been implanted and that for $SiO_2$ in which 15 mol % of phosphorus, for instance, has been implanted are 0.01 $\mu$m min and 1 $\mu$m/min, respectively, at 25°C, a difference on the order of 100 in the etching rate. When phosphorus

is implanted by $\mu$ ion beams with the ion current of 5 pA and 0.1 $\mu$m$\phi$, that is, 50 mA/cm$^3$ per unit area, the number of ions is 3 x 10$^{17}$/cm·sec. Since the SiO$_2$ layer has a thickness of 0.2 $\mu$m, therefore, the phosphorus implanted in 0.5 second is 7.5 x 10$^{21}$/cm$^3$ atoms, that is, about 15 mol %, per unit volume. In other words, if the etching is carried out using the aforesaid P-etching solution, the pipe-shaped phosphorus-implanted part 3 alone is etched to form a very fine etching hole 5, about 0.1 $\mu$m$\phi$, as shown in Fig. 3.

When SiO$_2$ is etched with a solution of HF etc. using a mask prepared by processing a conventional photoresist 6 (including electron beam resist and other resists), the etching proceeds isotropically to form a very large etching hole 5, even if the resist 6 could be provided with a hole of 0.1 $\mu$m$\phi$. Furthermore, when the hole of a photoresist is very small, the etching solution itself cannot enter the hole, so that the SiO$_2$ layer is far from being etched in such a case.

Now that this invention does not require any such defective photoresist mask, it can afford a very finely processed layer. In the conventional etching process, dry etching is made all over the wafer on which the photoresist partly remains, so that it is often attended by surface damage. In contrast, the process of this invention is free from such damage or stain on the Si substrate, because dry etching all over the substrate surface is unnecessary.

Example 2:

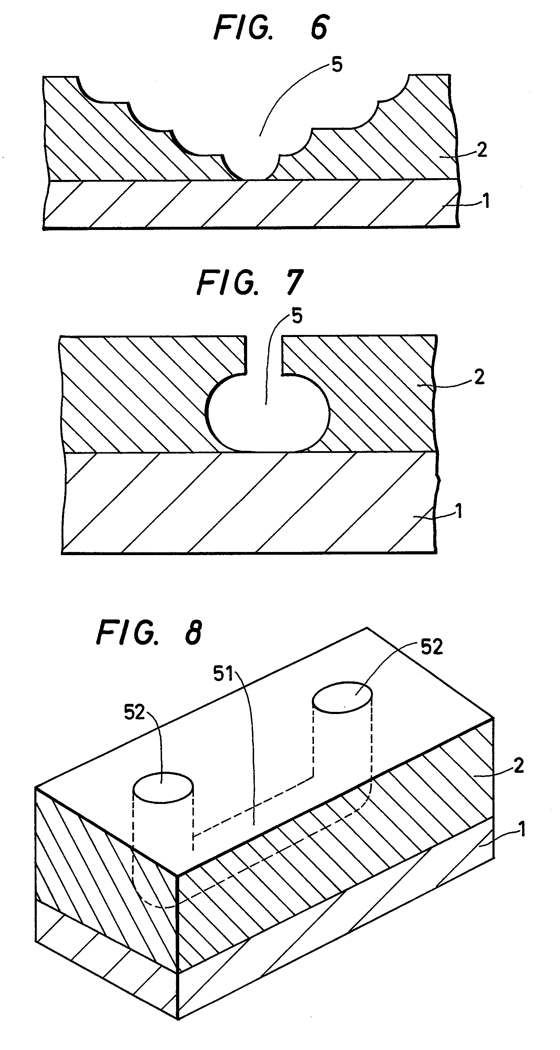

The process herein will be explained in reference to Figs. 5 and 6.

By the application of $\mu$-ion beams under varied energy and in varied diameter, it is made possible to form a phosphorus-implanted layer 3 having a gradual inclination as shown in Fig.5 and an etching hole 5 corresponding to the shape of the implanted layer 3 as shown in Fig. 6. The gradually inclined hole 5 produced as above is also advantageous in precision wiring, as the hole can be coated with a thin electrode film such as aluminum to give an electrode of high coverage.

Furthermore, it is possible for $\mu$-ion beams to create portions of high phosphorus concentration on arbitrary locations by changing the energy applied thereto, so that an etching hole having a broad bottom 5 can be produced as shown in Fig.7.

Example 3:

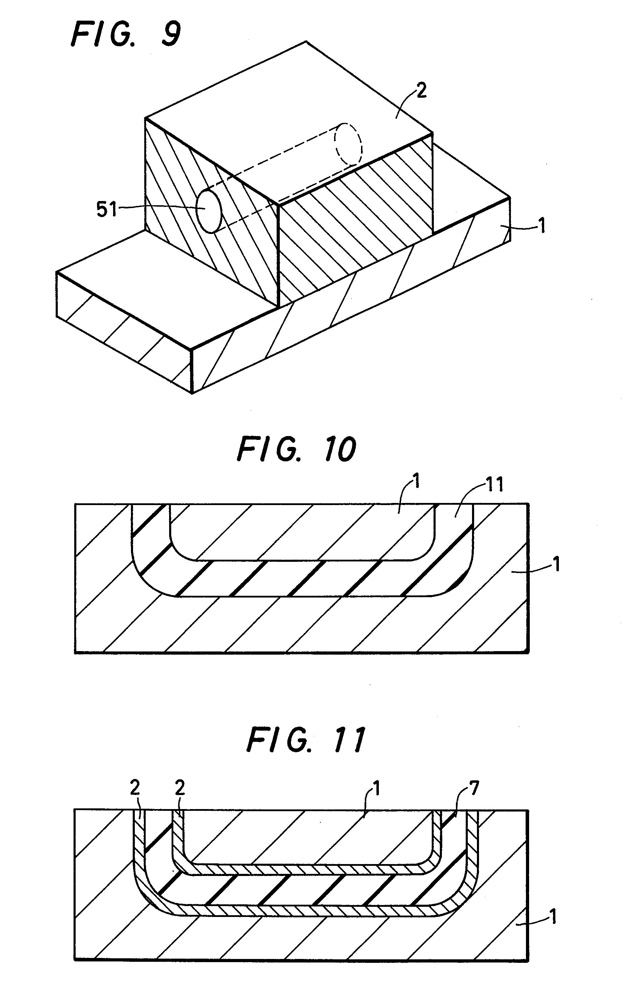

According to this invention, as shown in Fig. 8, it is also possible to produce a transverse hole 51 and a vertical hole 52 inside the $SiO_2$ layer containing phosphorus in peak concentration. The transverse hole 51 can be produced by implanting phosphorus under such a high energy as to leave no phosphorus on the surface, and the vertical hole 52 can be produced by applying the energy changing from a high to a low level so that the phosphorus can properly remain on the surface. As shown in Fig. 9, moreover, if the $SiO_2$ layer has previously been cut off on both sides and phosphorus is introduced inside under a high energy, a tunnel-shaped etching hole 51 can be produced. Furthermore, by changing the energy level continuously, it is also possible to produce a tunnel inclined to the surface of the $SiO_2$ layer 2, besides a horizontal tunnel.

In general, a conductive film made of polycrystalline silicon, etc., when applied by the CVD method or other means, can be deposited all round inside of said tunnel, whereby the wiring is made possible via this tunnel. Especially in the LSI manufacture using Si, necessary wiring can be facilitated with far less restriction, because the electrode wiring can be done after a $SiO_2$ layer has been formed and the layer need not be changed in its surface profile.

Example 4:

Another embodiment of this invention will now be described.

A mixed solution consisting of HF, $HNO_3$ and $CH_3COOH$ (1 : 3 : 8) which contains a small amount of $H_2O_2$ affords an etching rate of at most 10 $\overset{o}{A}$/min on the n-type Si containing impurities in a concentration of at most $10^{18}$ $cm^{-3}$, and 5 $\mu m$/min in case the impurity concentration is $10^{20}$ $cm^{-3}$. Accordingly, this invention is likewise applicable to a Si substrate as has been applied to the $SiO_2$ layer in the above-described example of the invention.

The p-type Si is grown epitaxially in the tunnel formed inside the n-type Si substrate, whereby a p-type region 11 is formed and a p-n junction is formed as shown in Fig. 10. Moreover, as shown in Fig. 11, a $SiO_2$ layer formed in the tunnel is coated with each crystalline Si 7, so that a wiring can be made in such a manner that it is electrically isolated from the substrate layer.

Example 5:

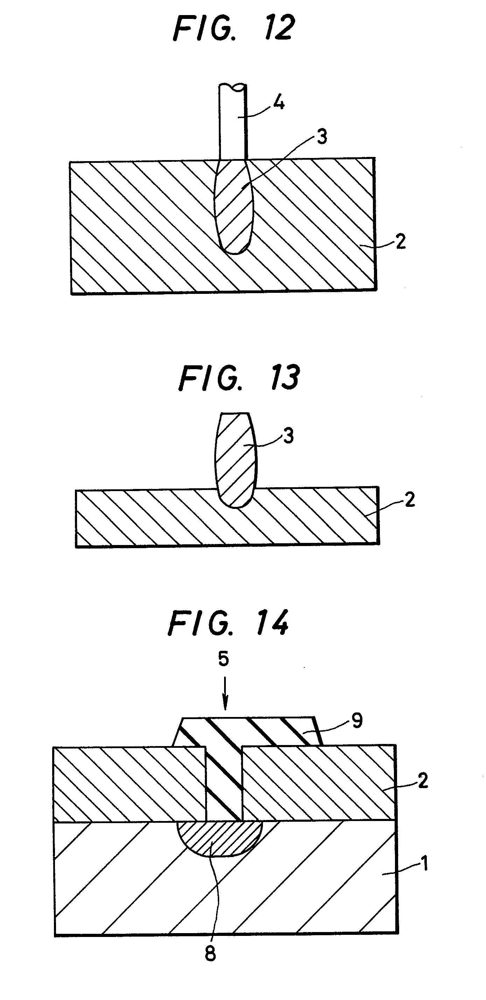

The aforesaid Examples are those utilizing the phenomenon that doped $\mu$-ion layers become susceptible to a specified etching solution. However, a reverse thereto can also apply to this invention. That is, a process as shown in Fig. 12 is possible: a $SiO_2$ layer is treated with nitrogen ions by $\mu$-ion doping and then subjected to heat treatment at about 1,000°C to give an oxy-nitride film, which is scarcely soluble in a solution of HF or the like. When the resulting layer is processed for etching, the doped $\mu$-ion layer 3 remains unchanged and the $SiO_2$ layer 2 as the substrate is etched, whereby a projected pattern is obtained as shown in Fig. 13.

The process of this example can be applied to Si as the substrate. When Si is treated, for instance, with an etching solution containing hydrazine (80%) at 50°C, the etching rate is 8 Å/min when the concentration of boron is at least $10^{20}$ $cm^{-3}$, and 120 Å/min when the boron concentration is at most $10^{18}$ $cm^{-3}$. (For polycrystalline Si, the etching rate is 80 Å/min.) Thus, a p-type or n-type substrate in a boron concentration of at most $10^{18}$ $cm^{-3}$ is processed for $\mu$-ion doping until the boron concentration reaches at least $10^{20}$ $cm^{-3}$, and is subsequently subjected to etching with hydrazine in the same manner as described above, whereby a projected Si column can be obtained likewise as in the process for the $SiO_2$ substrate in Fig. 13.

Example 6:

According to this invention, the substrate is made soluble or sparingly soluble in etching solutions depending on $\mu$-ion processes, and this means that the doping and the etching are self-aligned with each other:  At the same time as an etching hole 5 is formed on the $SiO_2$ layer 2 on the Si substrate by phosphorus being implanted therein by $\mu$-ion doping, an n-type region 8 can be formed by the phosphorus implanted in the Si substrate 1, as shown in Fig. 14.  (This figure is an instance showing that the n-type region has more or less been widened on diffusion by heat treatment following the implanting process.)  If an aluminum electrode 9 is subsequently installed, the n-type region 8 and the etching hole 5 are self-aligned with each other. Thus, the so-called mask  registration procedure is no longer necessary, and this is greatly advantageous in precision wiring in finer and denser configuration.

This invention has now made it possible to produce not only very fine patterns but also tunnel-shaped holes not emerging on the even surface, thereby facilitating the development of now wiring methods. Furthermore, it is possible that highly-doped $\mu$-ion layer and etching hole are self-aligned with each other, and favorable effects, such as a great advantage in high-density wiring, can be expected of this invention.

- 1 -

0148448

C L A I M S

1. An etching method comprising implanting one or more kinds of ions in a solid material (2; 1) by focused ion beams (4) and subsequently processing said solid material (2; 1) by a treatment method in which the etching rate varies with the kind of the implanted ion and its concentration.

2. An etching method as set forth in Claim 1, wherein said treatment method is a dry etching means using a gas.

3. An etching method as set forth in Claim 1, wherein said treatment method is a wet etching means using a solution.

# FIG. 1

# FIG. 2

2/5     0148448

FIG. 3

FIG. 4

FIG. 5

0148448

**FIG. 6**

**FIG. 7**

**FIG. 8**

## FIG. 9

2

51

1

## FIG. 10

1

11

1

## FIG. 11

2  2

1

7

1

FIG. 12

FIG. 13

FIG. 14